Europäisches Patentamt

European Patent Office

Office européen des brevets

(19)

(11) Publication number: **0 093 482**

**A1**

(12)

# EUROPEAN PATENT APPLICATION

(21) Application number: **83300459.1**

(22) Date of filing: **28.01.83**

(51) Int. Cl.³: **G 11 C 11/24**

(30) Priority: **28.01.82 GB 8202475**

(43) Date of publication of application:
**09.11.83 Bulletin 83/45**

(84) Designated Contracting States:
**DE FR IT NL**

(71) Applicant: **ITT INDUSTRIES INC.**
**320 Park Avenue**
**New York, NY 10022(US)**

(84) Designated Contracting States:
**FR IT NL**

(71) Applicant: **Deutsche ITT Industries GmbH**
**Hans-Bunte-Strasse 19 Postfach 840**
**D-7800 Freiburg(DE)**

(84) Designated Contracting States:
**DE**

(72) Inventor: **Harland, Robert**
**P.O. Box 314**
**Carp Ontario, KA0 1LO(CA)**

(74) Representative: **Dennis, Mark Charles et al,**
**STC Patent Department Edinburgh Way**
**Harlow Essex CM20 2SH(GB)**

(54) Semiconductor memory device.

(57) A sense and latch circuit for use as an input buffer for a dynamic RAM. An input voltage (I/P) is compared with a reference voltage ($V_{ref}$) by means of a cross-coupled sensing circuit (7,8,9) and steering transistors (3,4) for the sensing circuit which steer it to provide an output at one of two nodes (O/P, $\overline{O/P}$). Only three clock signals are required ($\theta_S$, $\theta_R$ and $\theta_{RH}$) in comparison with the four of conventional input buffers. Since the input is compared with a reference level the input threshold is independent of processing. The circuit provides fast latching of data and fast re-initialisation, as well as providing O/P and $\overline{O/P}$ signals.

EP 0 093 482 A1

Croydon Printing Company Ltd.

## SEMICONDUCTOR MEMORY DEVICES

This invention relates to semiconductor memory devices and in particular to a sense and latch circuit which can be used as an input buffer for dynamic RAM (random-access memory) applications.

According to the present invention there is provided a sense and latch circuit for dynamic logic applications, comprising a first MOS transistor to whose gate an input voltage is to be applied, a second MOS transistor to whose gate a reference voltage is to be applied, a cross-coupled sensing circuit, third and fourth MOS transistors comprising steering transistors for the sensing circuit, and first and second d.c. supply rails for the transistors and the sensing circuit, wherein in use when a sense clock signal is provided the differential gate voltages of the first and second MOS transistors are connected to respective first nodes between the sensing circuit and the steering transistors, wherein when the differential voltage between the nodes exceeds the threshold voltage of one of the steering transistors the sensing circuit is steered accordingly and an output provided at one of two output nodes of the circuit, and wherein means are provided for re-initialisation after sensing.

An embodiment of the present invention will now be described with reference to the accompanying drawings, in which:

Fig. 1 shows a circuit diagram of an input buffer employing the present invention, and

Fig. 2 shows the clock and output waveforms for the circuit of Fig. 1.

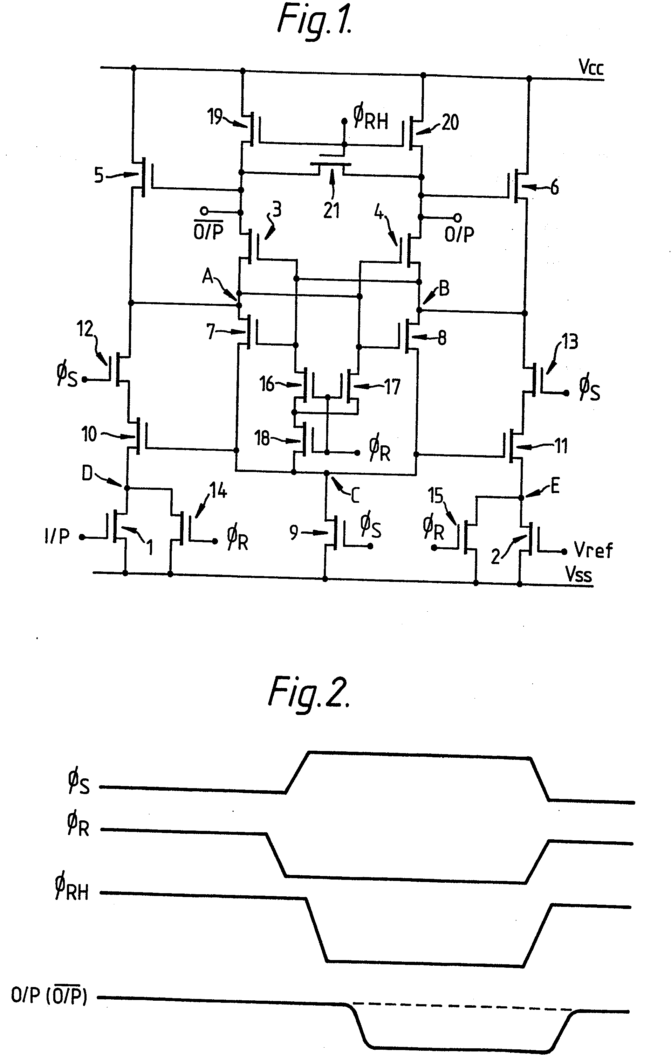

In the circuit of Fig. 1 an input voltage I/P is applied to the gate of an MOS transistor 1 and compared with a reference voltage $\dot{V}_{ref}$ applied to the gate of a MOS transistor 2, as described below.  The circuit includes first and second d.c. power supply rails $V_{SS}$ and $V_{CC}$ and twentyone MOS transistors 1 to 21.  Three clock pulses $\emptyset_S$, $\emptyset_R$ and $\emptyset_{RH}$ are employed.  MOS transistors 14, 15, 16, 17, 18, 19, 20 and 21 are used primarily for re-initialisation and are controlled by clock signals $\emptyset_R$ and $\emptyset_{RH}$.  Reset clock signal $\emptyset_R$ goes low and then sense clock signal $\emptyset_S$ goes high.  This then connects the different on-resistances, produced by the differential gate voltages of transistors 1 and 2 via MOS transistors 10 and 12, and 11 and 13 respectively to primary sense nodes A and B. Thus a cross-coupled sensing circuit comprising MOS transistors 7, 8 and 9 is steered and the differential voltage between nodes A and B amplified.

As sensing is performed node C falls, switching off MOS transistors 10 and 11, thus isolating transistors 1 and 2 and allowing the input voltage I/P to be changed without affecting the new "latched" data.

When the differential voltage between nodes A and B exceeds $V_T$, the steering transistor threshold voltage, one of the steering transistors, 3 or 4, will turn on , pulling down one of the precharged high output nodes (O/P or $\overline{O/P}$) and removing the gate drive of one of the load pull-ups comprised by MOS transistors 5 or 6.  $\emptyset_{RH}$ goes low at about this stage, according to the clock waveforms shown in Fig. 2. However, in other embodiments $\emptyset_{RH}$ may be arranged to go low earlier, for example prior to $\emptyset_R$. The output voltage O/P (or $\overline{O/P}$) is pulled to $V_{SS}$, having no opposing pull-up, while the output voltage $\overline{O/P}$ (or O/P) is left floating at $V_{CC}$. (See Fig. 2).

There are several ways to re-initialise the circuit, one of which is described below. When $\emptyset_S$ goes low $\emptyset_R$ goes high and transistors 16, 17 and 18 short out at nodes A, B and C, while $\emptyset_{RH}$ (a clock boosted above $V_{CC}$) pulls the outputs O/P and $\overline{O/P}$ to $V_{CC}$ via transistors 19 and 20, with transistor 21 shorting O/P and $\overline{O/P}$ together. Nodes A, B and C are, therefore, pulled to voltage $V_{CC} - V_T$ by pull-up transistors 5 and 6. Because nodes D and E are now isolated by MOS transistors 12 and 13 being off, the performance of the circuit may be improved by re-initialising nodes D and E to $V_{SS}$ via the transistors 14 and 15 respectively. This prevents any "memory" of the previous stage from affecting the "set-up time" of the next operation.

The circuit of the present invention compares the input voltage to a reference level and therefore the input threshold is independent of processing. A conventional input buffer circuits for dynamic RAMs employs four clock signals whereas the circuit of the present invention requires only three. In addition the circuit of the present invention provides fast latching of data and fast re-initialisation, as well as providing outputs O/P and $\overline{O/P}$.

0093482

CLAIMS:

1.   A sense and latch circuit for dynamic logic applications, comprising a first MOS transistor to whose gate an input voltage is to be applied, a second MOS transistor to whose gate a reference voltage is to be applied, a cross-coupled sensing circuit, third and fourth MOS transistors comprising steering transistors for the sensing circuit, and first and second d.c. supply rails for the transistors and the sensing circuit, wherein in use when a sense clock signal is provided the differential gate voltages of the first and second MOS transistors are connected to respective first nodes between the sensing circuit and the steering transistors, wherein when the differential voltage between the nodes exceeds the threshold voltage of one of the steering transistors the sensing circuit is steered accordingly and an output provided at one of the two output nodes of the circuit, and wherein means are provided for re-initialisation after sensing.

2.   A circuit as claimed in claim 1, wherein as sensing is performed the first and second transistors are isolated from the sensing circuit whereby to allow change of the input voltage.

3.   A circuit as claimed in claim 1 or claim 2 including fifth and sixth MOS transistors comprising load pull-up transistors, one being associated with each output node.

4.   A circuit as claimed in any one of the preceding claims, wherein the sensing circuit comprises seventh, eighth and ninth MOS transistors, the sources of the seventh and eighth transistors being coupled together and to the drain of the ninth resistor, whose source is connected to the first supply rail and to whose gate the sense clock signal is applied, the drains of the seventh and eighth transistors being separately connected to the second power rail via the third and fourth transistors respectively, wherein the gates of the seventh MOS transistor and the third transistor are connected together and to a third node which is between the eighth transistor and the fourth transistor, and wherein the gates of the eighth MOS transistor and the fourth transistor are connected together and to a fourth node which is between the seventh transistor and the third transistor.

5. A circuit as claimed in claim 4 as appendant to claim 2, further including a tenth MOS transistor connected in series with the first transistor between the power rails, and an eleventh MOS transistor connected in series with the second transistor, wherein the gates of the tenth and eleventh transistors are connected together and to the sources of the seventh and eighth transistors, wherein in use the gate voltages of the tenth and eleventh transistors decrease below their threshold values during sensing whereby the tenth and eleventh transistors are switched off and isolate the first and second transistors.

6. A circuit as claimed in claim 5, further including a twelfth MOS transistor connected in series with the first transistor and a thirteenth MOS transistor connected in series with the second transistor, which twelfth and thirteenth transistors serve to isolate the first and second transistors, respectively, from the sensing circuit between sensing clock pulses.

- 7 -

0093482

10. A sense and latch circuit for use as an input buffer for a dynamic RAM substantially as herein described with reference to and as illustrated in the accompanying drawings.

11. An integrated logic circuit having a sense and latch circuit according to any preceding claim.

0093482

1/1

Fig.1.

Fig.2.

# 0093482

European Patent Office

**EUROPEAN SEARCH REPORT**

Application number

EP 83 30 0459

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | US-A-3 976 895 (BELL TELEPHONE LABORATORIES) * Whole document * | 1,3,4, 10 | G 11 C 11/24 |
| X | IEEE INTERNATIONAL SOLID-STATE CIRCUITS CONFERENCE, 15th February 1979, pages 140-141, New York, USA R.C. FOSS et al.: "THPM 12.1-INVITED: The design of MOS dynamic RAMs" * Figure 4 * | 1-6,10 | |
| X | PATENTS ABSTRACTS OF JAPAN, vol. 4, no. 168(P-37)(650), 20th November 1980 & JP - A - 55 113 192 (HITACHI SEISAKUSHO K.K.) 01-09-1980 * Whole abstract * | 1-6,10 | |

TECHNICAL FIELDS SEARCHED (Int. Cl. 3)

G 11 C 11/24

The present search report has been drawn up for all claims

| Place of search THE HAGUE | Date of completion of the search 01-07-1983 | Examiner DEGRAEVE L.W.G. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82